# FASCICULE DE BREVET EUROPEEN

(11) **EP 3 948 966 B1**
(45) Date de publication et mention de la délivrance du brevet: **08.11.2023**
(21) Numéro de dépôt: 20712608.7
(22) Date de dépôt: 26.03.2020
(51) Int. Cl.: H10N 30/072, H10N 30/086

(54) **PROCÉDÉ DE PRÉPARATION D'UNE COUCHE MINCE DE MATÉRIAU FERROÉLECTRIQUE**
VERFAHREN ZUR HERSTELLUNG EINER DÜNNEN SCHICHT AUS FERROELEKTRISCHEM MATERIAL
METHOD FOR PREPARING A THIN LAYER OF FERROELECTRIC MATERIAL

(30) Priorité: 29.03.2019 FR 1903359
(43) Date de publication de la demande: 09.02.2022
(73) Titulaire: SOITEC, 38190 Bernin (FR)
(72) Inventeur: DROUIN, Alexis, 38530 La Buissière (FR); HUYET, Isabelle, 38920 Crolles (FR); LOGIOU, Morgane, 38920 Crolles (FR)
(74) Mandataire: IP Trust
(86) Numéro de dépôt international: PCT/EP2020/058460
(87) Numéro de publication internationale: WO 2020/200986

(56) Documents cités:
- FR-A1- 3 068 508
- FR-A1- 3 078 822
- US-A1- 2017 062 698
- US-B1- 6 593 212

## Description

### DOMAINE DE L'INVENTION

La présente invention concerne un procédé de préparation d'une couche mince de matériau ferroélectrique. Plus particulièrement, elle concerne un procédé de préparation permettant de maintenir le caractère monodomaine du matériau ferroélectrique dans la couche mince du produit final. Ce procédé de préparation est utilisé, par exemple, dans les domaines de la microélectronique, de la micromécanique, de la photonique...

### ARRIERE PLAN TECHNOLOGIQUE DE L'INVENTION

En préambule on rappelle qu'un matériau ferroélectrique est un matériau qui possède une polarisation électrique à l'état naturel, polarisation qui peut être renversée par l'application d'un champ électrique extérieur. On appelle domaine ferroélectrique, chaque région d'un seul tenant du matériau dans lequel la polarisation est uniforme (tous les moments dipolaires sont alignés parallèlement les uns aux autres suivant une direction donnée). Un matériau ferroélectrique peut donc être caractérisé de « monodomaine » dans le cas où ce matériau est constitué d'une seule région dans laquelle la polarisation est uniforme ou de « multidomaine » dans le cas où le matériau ferroélectrique comprend une pluralité de régions présentant des polarités pouvant être différentes.

On connaît de l'état de la technique différents procédés permettant de former une couche mince de matériau ferroélectrique. Il peut s'agir, par exemple, d'une technique d'épitaxie par jet moléculaire (« Molecular Beam Epitaxy » en anglais), de pulvérisation plasma (« Plasma Sputtering » en anglais), dépôt par plasma (« Laser Pulsed Déposition » en anglais), ou encore de l'application de la technologie Smart Cut^{™} selon laquelle une couche mince est prélevée d'un substrat massif en matériau ferroélectrique par fracture au niveau d'une zone fragile (ou plan de fragilisation) formée dans le substrat massif par implantation d'espèces légères.

La présente invention concerne plus particulièrement la préparation d'une couche mince ferroélectrique obtenue par l'application d'un tel procédé. Le document US20100088868 note qu'une couche ferroélectrique de tantalate de lithium transférée par un procédé mettant en oeuvre une implantation d'hydrogène conduit à former une couche multidomaine. Une telle caractéristique rend la couche impropre à son utilisation, car elle affecte les performances des dispositifs qui sont appelés à être formés sur/dans la couche mince, comme par exemple des dispositifs acoustiques à ondes de surface (SAW).

Le document FR3068508 divulgue la finition d'une couche mince ferroélectrique reportée sur un support par l'intermédiaire d'une couche intermédiaire, et par application du procédé Smart Cut. Dans un exemple, cette finition comprend un traitement thermique de la couche mince, suivi d'un polissage. Selon ce document, cette séquence permettrait de restaurer les propriétés monodomaine initiale de la couche mince ferroélectrique. Des analyses complémentaires menées par la demanderesse ont toutefois montré que cette séquence de finition ne pouvait garantir à elle seule le caractère monodomaine de la couche sur toute son épaisseur, c'est à dire de son interface avec le couche intermédiaire jusqu'à sa surface libre. Plus particulièrement, ces analyses par mesure PFM (pour « **Piezoresponse force microscopy** » ou « microscopie à force piézoélectrique ») qui s'étendent généralement sur une profondeur d'environ 50nm de la surface de mesure, ont confirmé que la portion superficielle de la couche mince était bien monodomaine, mais qu'un portion enterrée juxtaposée à la couche intermédiaire pouvait se révéler être multidomaine. Pour procéder à cette mesure « enterrée » par PFM, la couche a été progressivement amincie par polissage mécano chimique afin d'approcher la surface de mesure de cette couche intermédiaire.

On connaît aussi du document FR2914492 un procédé de fabrication d'une couche mince de matériau ferroélectrique mettant en oeuvre la technologie Smart Cut. Dans ce document comme dans le document US20100088868 précité, la couche prélevée et reportée sur un substrat support est préparée en la soumettant à un champ électrique de manière à améliorer ou à restaurer ses propriétés ferroélectriques monodomaine. Un tel traitement nécessite la présence d'une paire d'électrodes disposée de part et d'autre de la couche ferroélectrique à traiter, par exemple en contact électrique avec cette couche. Il n'est pas toujours possible de disposer d'une telle paire d'électrodes, notamment lorsque la couche ferroélectrique est reportée sur un substrat isolant électriquement ou sur une couche d'isolant électrique.

### OBJET DE L'INVENTION

Un but de l'invention est de proposer un procédé de préparation d'une couche mince de matériau ferroélectrique adressant en partie au moins les inconvénients précités. Elle vise plus particulièrement un procédé de report d'une couche de matériau ferroélectrique mettant en oeuvre une étape d'implantation d'espèce légères, le procédé préservant ou étant apte à restaurer la qualité monodomaine de la couche reportée sur toute son épaisseur. Il n'est donc pas nécessaire dans le procédé de préparation de la couche de la soumettre à un champ électrique pour restaurer sa qualité monodomaine et on peut la reporter sur un substrat électriquement isolant ou muni d'une couche diélectrique.

### BREVE DESCRIPTION DE L'INVENTION

En vue de la réalisation de ce but, l'objet de l'invention propose un procédé de préparation d'une couche mince monodomaine en matériau ferroélectrique comprenant les étapes suivantes :
- une implantation d'espèces légères dans une première face d'un substrat donneur ferroélectrique pour former un plan de fragilisation et définir une première couche entre le plan de fragilisation et la première face du substrat donneur;
- l'assemblage de la première face du substrat donneur à un substrat support par l'intermédiaire d'une couche d'assemblage diélectrique;
- la fracture du substrat donneur au niveau du plan de fragilisation pour reporter la première couche sur le substrat support et exposer une face libre de la première couche;
- la finition de la première couche, cette finition comprenant un traitement thermique de la face libre de la première couche, suivi d'un amincissement de la première couche pour former la couche mince monodomaine ;

Selon l'invention, la couche d'assemblage diélectrique comprenant un oxyde présente une concentration d'hydrogène inférieure à celle de la première couche ou prévient la diffusion d'hydrogène vers la première couche, ou la couche d'assemblage diélectrique comprend une barrière prévenant la diffusion d'hydrogène vers la première couche.

De manière surprenante, cette succession précise d'étapes de préparation combinée à la nature particulière de la couche d'assemblage conduit à former une couche mince finale présentant une polarisation monodomaine sur toute son épaisseur et une qualité cristalline et de surface satisfaisantes.

Selon d'autres caractéristiques avantageuses et non limitatives de l'invention, prises seules ou selon toute combinaison techniquement réalisable :
- l'amincissement comprend un polissage mécano-chimique appliqué sur la face libre de la première couche ;
- le traitement thermique s'effectue à une température comprise entre 300°C et la température de Curie du matériau ferroélectrique composant la première couche, et pendant une durée comprise entre 30 minutes et 10 heures ;
- le traitement thermique s'effectue sous une atmosphère gazeuse oxydante ou neutre ;
- le substrat donneur comprend un matériau ferroélectrique choisi parmi du LiTaO3 ou du LiNbO3 ;
- le matériau ferroélectrique présente une direction cristalline comprise entre 30° et 60°RY ;
- le matériau du substrat support est du silicium ;
- le substrat donneur est un bloc de matériau massif ;
- le substrat donneur comprend une couche épaisse en matériau ferroélectrique disposée sur un substrat manipulateur ;
- lequel le substrat manipulateur présente un coefficient de dilatation thermique identique ou proche du coefficient de dilatation thermique du support ;
- le matériau de la première couche et le matériau du substrat support présentent des coefficients de dilatation thermique différents ;
- le substrat support est muni d'une couche de piégeage de charges ;
- la couche d'assemblage diélectrique comprend un oxyde présentant de l'azote dans un ratio azote/ oxygène supérieur ou égale à 0,01 ou 0,05 ;
- la couche d'assemblage diélectrique comprend un oxyde de silicium présentant de l'azote dans un ratio azote/ oxygène compris entre 0,01 et 0,25 ou entre 0,05 et 0,01 ;
- la couche d'assemblage diélectrique est formée d'un empilement comprenant une première couche d'oxyde disposé du côté du substrat support et d'une couche de nitrure de silicium disposée du côté de la première couche ;

Selon un autre aspect, l'invention propose un dispositif comprenant :
- une couche mince entièrement monodomaine en matériau ferroélectrique ;
- une couche d'assemblage diélectrique en contact avec la couche mince et comprenant un oxyde prévenant la diffusion d'hydrogène vers la couche mince, ou comprenant une barrière prévenant la diffusion d'hydrogène vers la couche mince;
- un support en contact avec la couche diélectrique.

Selon d'autres caractéristiques avantageuses et non limitatives de cet aspect de l'invention, prises seules ou selon toute combinaison techniquement réalisable :
- le substrat support est muni d'une couche de piégeage de charges disposé entre une partie massive du support et la couche d'assemblage diélectrique ;
- la couche d'assemblage diélectrique comprend un oxyde présentant de l'azote dans un ratio azote/ oxygène supérieur ou égale à 0,01 ou 0,05 ;
- la couche d'assemblage diélectrique comprend un oxyde de silicium présentant de l'azote dans un ratio azote/ oxygène compris entre 0,01 et 0,25 ou entre 0,05 et 0,01 ;
- la couche d'assemblage diélectrique est formée d'un empilement comprenant une première couche d'oxyde disposé du côté du substrat support et d'une couche de nitrure de silicium disposée du côté de la couche mince.

### BREVE DESCRIPTION DES FIGURES

D'autres caractéristiques et avantages de l'invention ressortiront de la description détaillée de l'invention qui va suivre en référence aux figures annexées sur lesquels :
Les figures 1A à 1D présentent un premier mode de réalisation d'un procédé conforme à l'invention ;
Les figures 2A à 2D présentent un deuxième mode de réalisation d'un procédé conforme à l'invention ;
La figure 3 représente schématiquement un procédé de préparation d'une couche conforme à l'invention ;
La figure 4 représente un dispositif acoustique de surface qui peut être réalisée à l'aide d'un procédé conforme à la présente invention.

### DESCRIPTION DETAILLEE DE L'INVENTION

Par souci de simplification de la description à venir, les mêmes références sont utilisées pour des éléments identiques ou assurant la même fonction dans les différents modes de mise en oeuvre exposés du procédé.

Les figures sont des représentations schématiques qui, dans un objectif de lisibilité, ne sont pas à l'échelle. En particulier, les épaisseurs des couches ne sont pas à l'échelle par rapport aux dimensions latérales de ces couches.

L'expression « coefficient de dilatation thermique » employée dans la suite de cette description en relation à une couche ou à un substrat fait référence au coefficient de dilatation selon une direction définie dans le plan principal définissant cette couche ou ce substrat. Si le matériau est anisotrope, la valeur du coefficient retenue sera celle de plus grande amplitude. La valeur du coefficient est celle mesurée à température ambiante.

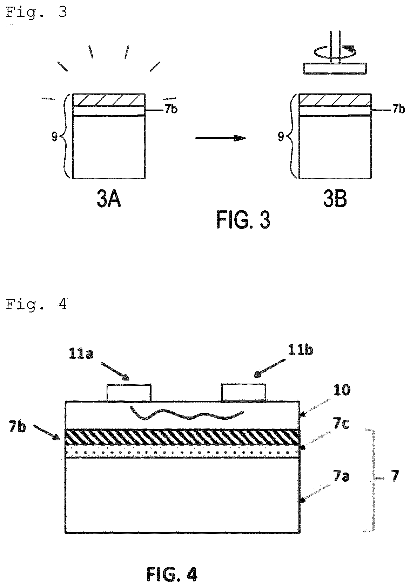

La figure 4 représente un dispositif acoustique de surface qui peut être réalisée à l'aide d'un procédé conforme à la présente invention.

Une couche mince ferroélectrique 10 est disposée directement en contact avec un support 7, par l'intermédiaire d'une couche diélectrique 7b. Des électrodes métalliques 11a, 11b sont agencées sur la couche mince ferroélectrique 10. Comme cela est bien connu en soi, un signal électrique de haute fréquence appliqué à l'une des électrodes se propage dans la couche mince ferroélectrique 10 sous la forme d'une onde de surface pour y être traité (par exemple filtré) et récupéré sur l'autre électrode. Les caractéristiques de la couche mince ferroélectrique 10 et plus généralement de l'ensemble des couches formant l'empilement sur laquelle la couche mince ferroélectrique 10 repose, sont déterminantes pour réaliser le traitement recherché du signal électrique, notamment l'épaisseur et la qualité cristalline monodomaine de la couche mince ferroélectrique 10.

Les caractéristiques du support 7 peuvent affecter, par couplage acoustique, la propagation de l'onde dans la couche mince 10. La nature et l'épaisseur de ces couches peuvent donc également être déterminantes pour réaliser le traitement recherché du signal électrique, ou pour le moins influencer ce traitement. Dans l'exemple représenté sur la figure 4, le support 7 comprend une partie massive en silicium 7a, et une couche d'assemblage diélectrique 7b, de préférence comprenant un oxyde, directement en contact avec la couche mince ferroélectrique 10. A titre d'exemple, la couche d'assemblage 7b peut être en oxyde de silicium, en nitrure de silicium, ou être formée d'un empilement de couches composées de ces matériaux. De préférence, le support 7 est électriquement résistif, afin d'éviter de se coupler électriquement avec les signaux haute fréquence appliqués sur les électrodes 11a, 11b, ce qui pourrait affecter leur propagation. La partie massive 7a peut ainsi être constituée d'un substrat de silicium haute résistivité, c'est-à-dire présentant une résistivité supérieure à 1000 ohm-centimètre, et plus préférentiellement encore supérieure à 3000 ohm-centimètre.

Pour appuyer le caractère résistif du support 7, on a prévu d'insérer dans l'exemple de la figure 4, entre la partie massive 7a et la couche d'assemblage 7b, une couche de piégeage de charges 7c par exemple formé de silicium polycristallin. La formation d'une telle couche et son rôle contribuant à la résistivité du substrat support 7 sont bien connus en soi et on pourra en trouver une description détaillée dans les documents FR2860341, FR2933233, FR2953640, US2015115480. On peut bien entendu prévoir de former cette couche de piégeage de charges 7c par d'autre technique que celle prévoyant une couche formée de silicium polycristallin. Cette couche peut également comprendre du carbone ou être constituée ou comprendre du carbure de silicium ou un alliage de silicium et de carbone. Il peut alternativement exemple s'agir de réaliser les pièges électriques dans la couche 7c par bombardement ionique d'espèces relativement lourdes (par exemple de l'argon) dans une partie superficielle du support afin d'y créer des défauts cristallins apte à piéger des charges électriques. On peut également prévoir une couche de piégeage de charges 7c formée d'une matière poreuse, par exemple par porosification d'une partie superficielle du substrat 7 lorsque celui-ci est en silicium.

On note que le dispositif représenté sur la figure 4 ne prévoit pas d'électrodes sous la couche mince ferroélectrique 10. La présence de la couche d'assemblage diélectrique 7b ne permet pas de prendre contact avec la face arrière de la couche mince ferroélectrique 10. On ne peut donc pas exploiter la présence d'une telle électrode ou la formation d'un contact électrique pour polariser la couche mince 10 ferroélectrique comme cela est documenté dans l'état de la technique cité en introduction de la demande.

Il est donc important de disposer d'un procédé de préparation de la couche mince ferroélectrique 10 qui puisse préserver ou restaurer la caractéristique monodomaine de cette couche 10, sans nécessiter l'application d'une tension de repolarisation.

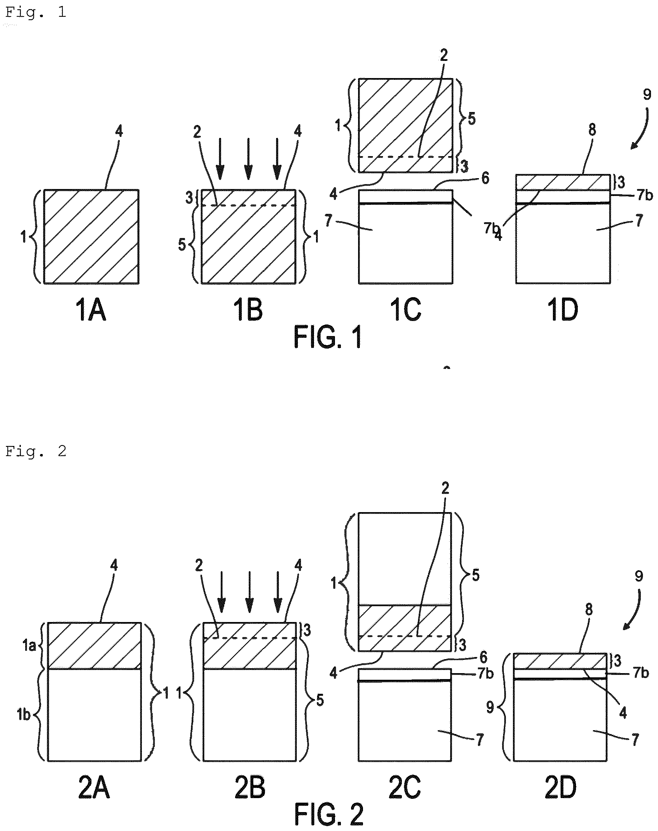

En référence aux figures 1 et 2, et pour permettre la réalisation du dispositif représenté sur la figure 4, l'invention prévoit généralement de reporter une première couche ferroélectrique 3 sur un substrat support 7, la première couche 3 étant prélevée d'un substrat donneur 1 ferroélectrique monodomaine par une technique de transfert fondée sur l'implantation d'espèces légères tels que des espèces d'hydrogène.

Selon cette technique, on implante de l'hydrogène dans une première face 4 du substrat donneur 1 pour y former un plan de fragilisation enterré 2. On définit de la sorte une première couche 3 entre le plan de fragilisation 2 et la première face 4 du substrat donneur 1. Puis on assemble la première face 4 du substrat donneur 1 avec un support 7, ici par l'intermédiaire d'une couche d'assemblage diélectrique 7b. On fracture ensuite le substrat donneur 1 au niveau du plan de fragilisation 2, par exemple à l'aide d'un traitement thermique modéré et/ou l'application d'un effort mécanique. On libère alors la première couche 3 du substrat donneur 1 pour exposer une face libre 8 de la première couche, l'autre face 4 de la couche mince étant directement en contact avec la couche d'assemblage 7b du substrat support 7.

Il est généralement nécessaire de prévoir des étapes de préparation de la première couche 3 transférée ainsi reportée sur le support 7, pour former une couche mince « utile » 10. Ces étapes visent généralement à améliorer la qualité cristalline de la couche mince 10 et son état de surface (par exemple sa rugosité). Ces étapes de préparation peuvent comprendre une étape d'amincissement de la première couche 3 (par exemple par polissage mécano-chimique, désigné par « CMP » dans le tableau ci-dessous) et/ou une étape de traitement thermique (dans le cas d'un matériau ferroélectrique, il peut s'agir d'un traitement thermique de l'ordre de 500°C dans une atmosphère neutre ou comprenant de l'oxygène, désignés par « TTH » dans le tableau ci-dessous). On notera que cette étape de traitement thermique de la face libre 8 de la couche 3 est distincte de celle ayant conduit à la fracture du substrat donneur. En effet, la couche 3 n'ayant pas encore été entièrement libérée lors du recuit de fracture, ce traitement thermique ne peut en traiter une face libre.

La demanderesse a toutefois observé qu'un procédé de préparation d'une première couche 3 reportée sur le substrat support 7 visant à former une couche mince 10 pouvait conduire à la création d'une pluralité de domaines ferroélectriques au sein de la couche mince 10, lui attribuant alors un caractère de multidomaine. Comme on l'a déjà un énoncé, une telle caractéristique rend la couche impropre à son utilisation, car elle affecte les performances des dispositifs qui sont appelées à être formées sur/dans la couche mince transférée, comme par exemple des dispositifs acoustiques de surface similaires à celui représenté sur la figure 4.

Les inventeurs de la présente demande ont observé que la nature et la séquence des étapes de préparation de la première couche 3 pouvaient grandement affecter les propriétés ferroélectriques de la couche mince 10. A partir de ces premières observations, les inventeurs de la présente demande ont procédé à une analyse des différents enchaînements d'étapes de préparation mettant en oeuvre une technique de microscopie par force piézoélectrique (PFM) pour caractériser le caractère monodomaine ou multidomaine de la surface de la couche mince 10. Ces expériences sont résumées dans le tableau ci-dessous.

**[Tableau 1]**

| Etape 1 | Etape 2 | Remarque |
|---|---|---|
| Pas d'étape de préparation de la couche mince | | Monodomaine, propriétés de surface et/ou cristalline impropre à l'utilisation |
| CMP | | Monodomaine, propriétés de surface et/ou cristalline impropre à l'utilisation |
| TTH | | Multidomaine |
| CMP | TTH | Multidomaine (procédé de préparation usuel) |
| TTH | CMP | **Monodomaine** |

On observe (1ere ligne du tableau) que la première couche 3 obtenue à l'issue de l'étape de détachement, et avant toute préparation, présente des qualités ferroélectriques conformes, c'est-à-dire monodomaine. Toutefois, l'état de surface et la qualité cristalline de cette couche nécessitent l'application d'étapes de préparation.

La ligne 4 du tableau correspond à l'application du procédé enchainant un amincissement et un traitement thermique (CMP + TTH), et on observe que la couche mince présente à l'issue de ce traitement une caractéristique ferroélectrique multidomaine.

Les lignes 2 et 3 représentent respectivement l'application d'une unique étape d'amincissement CMP ou de traitement thermique TTH. L'une et l'autre de ces étapes conduisent à des propriétés de la couche mince 3 non conformes.

La demanderesse s'est rendue compte en appliquant successivement une étape de traitement thermique TTH suivie d'une étape d'amincissement CMP, que la couche mince 10 obtenue présentait une répartition monodomaine, telle qu'observée en surface de cette couche par PFM, de sa polarisation ferroélectrique et une qualité cristalline et de surface acceptable.

Des analyses complémentaires menées par la demanderesse ont permis d'identifier que la formation de domaines ferroélectriques multiples dans la couche mince 10 pouvait être liée à la présence d'un fort gradient de concentration d'hydrogène dans la première couche 3 avant sa préparation. Il a en effet été observé que l'application d'un traitement thermique sur une couche présentant un tel gradient conduit à former une pluralité de domaines ferroélectriques. L'hydrogène implanté dans le substrat donneur 1 au cours de l'étape de définition de la première couche 3 se répartit dans ce substrat selon un profil présentant un pic de concentration au niveau du plan de fragilisation 2. Après fracture, la première couche 3 ferroélectrique reportée sur le substrat support 7 présente ainsi une concentration importante d'hydrogène, de l'ordre de 10^21 at/cm^3, au niveau de sa face libre 8. Cette concentration décroît dans l'épaisseur de la couche mince en direction du support 7, pour atteindre un niveau de l'ordre de 10^19 at/cm^3.

Lorsque les étapes de préparation sont composées d'une première étape d'amincissement de la première couche 3 pour amener son épaisseur à l'épaisseur cible de la couche mince 10 suivie d'un traitement thermique, ce dernier s'applique alors que la couche amincie présente encore un fort gradient d'hydrogène, notamment dans une portion superficielle de la couche amincie. Cela conduit à transformer une épaisseur ou portion superficielle de la couche mince 10, dans laquelle le gradient d'hydrogène est important, en une pluralité de domaines ferroélectriques.

Lorsqu'on inverse ces deux étapes, la portion superficielle de la première couche 3 présentant un fort gradient de concentration en hydrogène est transformée pour présenter une pluralité de domaines ferroélectriques. Toutefois, cette portion superficielle multidomaine de la première couche 3 est éliminée par l'étape suivante d'amincissement. Cela permet de fournir une couche mince 10 présentant la qualité requise monodomaine.

On note que le traitement thermique, qu'il soit mené avant ou après l'étape d'amincissement, conduit à faire diffuser l'hydrogène dont la couche est gorgée, et réduire le gradient dans l'épaisseur de cette couche. Les traitements thermiques qui pourraient s'appliquer ultérieurement à la préparation de la couche mince 10 sont donc moins susceptibles d'affecter le caractère monodomaine de cette couche.

Des analyses très poussées mettant en oeuvre une observation par microscopie à force piézoélectrique de la couche mince 10, après que celle-ci ait été amincie, ont également révélé que cette couche mince 10 pouvait présenter une portion enterrée multidomaine, en contact avec la couche d'assemblage. Cette portion enterrée multidomaine n'est pas facilement visible par une simple observation PFM de surface, dont la mesure est limitée à une profondeur d'environ 50nm

A partir d'observations PFM de la couche amincie pour de multiples échantillons, la demanderesse a déterminé que la nature de la couche d'assemblage diélectrique 7b jouait un rôle important vis-à-vis de la redistribution de l'hydrogène dans la couche ferroélectrique au cours du traitement thermique du procédé de préparation de la couche mince 10.

Lorsque la couche d'assemblage 7b est riche en hydrogène, comme cela peut être le cas de certains oxydes ou diélectriques déposés, elle forme une source d'hydrogène que le traitement thermique peut faire migrer dans la couche ferroélectrique avec laquelle elle est en contact. Cet hydrogène peut notamment s'accumuler dans la couche ferroélectrique au niveau de l'interface de cette couche avec la couche d'assemblage 7b. Cette migration et cette accumulation peuvent constituer un gradient de concentration d'hydrogène rendant possible la transformation multidomaine d'une portion de la couche ferroélectrique en contact avec la couche d'assemblage au cours du traitement thermique.

Lorsqu'au contraire la couche d'assemblage 7b est relativement pauvre en hydrogène, c'est-à-dire qu'elle présente une concentration d'hydrogène inférieure à celle présente dans la couche ferroélectrique reportée, l'hydrogène en excès dans la couche ferroélectrique peut être absorbé dans la couche d'assemblage 7b lors de la diffusion provoquée par le traitement thermique. On prévient ainsi l'accumulation d'hydrogène à l'interface d'assemblage et on évite une transformation mutlidomaine dans la portion de la couche ferroélectrique à proximité de cette interface.

L'invention met à profit ces résultats et observations pour proposer un procédé de préparation de la couche mince 10. Plus particulièrement, l'invention concerne un procédé de préparation d'une couche mince 10 en un matériau ferroélectrique transférée d'un substrat donneur 1 sur un substrat support 7 par une technique de transfert incluant une implantation d'espèces légères tels que des espèces d'hydrogène, tel que cela a été présenté précédemment d'une manière très générale. Plusieurs modes de réalisation existent pour effectuer ce transfert.

Suivant un premier mode de réalisation, représenté sur les figures 1A à 1D, le substrat donneur 1 est composé d'un bloc massif et monodomaine de matériau ferroélectrique, par exemple de LiTaO3, LiNbO3, LiAlO3, BaTiO3, PbZrTiO3, KNbO3, BaZrO3, CaTiO3, PbTiO3 ou de KTaO3. Le substrat donneur 1 peut prendre la forme d'une plaquette, circulaire, de dimension normalisée, par exemple de 150 mm ou 200 mm de diamètre. Mais l'invention n'est nullement limitée à ces dimensions ou à cette forme. Le substrat donneur 1 peut avoir été prélevé d'un lingot de matériaux ferroélectrique, ce prélèvement ayant été réalisé de manière à ce que le substrat donneur 1 présente une orientation cristalline prédéterminée. L'orientation est choisie en fonction de l'application visée. Ainsi, il est usuel de choisir une orientation comprise entre 30° et 60°RY, ou entre 40° et 50°RY, dans le cas où l'on souhaite exploiter les propriétés de la couche mince pour former un filtre SAW. Mais l'invention n'est nullement limitée à une orientation cristalline particulière.

Quelle que soit l'orientation cristalline du substrat donneur 1, le procédé comprend l'introduction d'hydrogène dans ce substrat donneur 1. Cette introduction peut correspondre à une implantation d'hydrogène, c'est-à-dire, un bombardement ionique d'hydrogène de la face plane 4 du substrat donneur 1. On peut naturellement prévoir que cette introduction d'hydrogène, par exemple par implantation, soit complétée par l'introduction d'autres espèces légères, telle que de l'hélium.

De façon connue en soi, et comme cela est représenté sur la figure 1B, les ions implantés ont pour but de former un plan de fragilisation 2 délimitant une première couche 3 de matériau ferroélectrique à transférer qui est située du côté de la face 4 et une autre partie 5 formant le reste du substrat.

La nature, la dose des espèces implantées et l'énergie d'implantation sont choisies en fonction de l'épaisseur de la couche que l'on souhaite transférer et des propriétés physico-chimiques du substrat donneur 1. Dans le cas d'un substrat donneur 1 en LiTaO3, on pourra ainsi choisir d'implanter une dose d'hydrogène comprise entre 1^{E}16 et 5^{E}17 at/cm² avec une énergie comprise entre 30 et 300keV pour délimiter une première couche 3 de l'ordre de 200 à 2000 nm.

Dans une étape suivante, représentée sur la figure 1C, on assemble la face plane 4 du substrat donneur 1 avec une face 6 d'un substrat support 7. Le substrat support 7 peut présenter la même dimension et la même forme que celles du substrat donneur 1. Pour des raisons de disponibilité et de coût, le substrat support 7 est une plaquette de silicium, monocristallin ou polycristallin. Mais plus généralement, le substrat support 7 peut être constitué de tout matériau, par exemple du silicium, même électriquement isolant tel que du saphir ou du verre, et présenter toute forme. Pour former le dispositif représenté sur la figure 4, on choisira un substrat support formé d'une partie massive 7a en silicium hautement résistif muni d'une couche de piégeage de charge 7b, par exemple en silicium polycristallin.

Préalablement à l'étape d'assemblage, il peut être envisagé de préparer les faces des substrats à assembler par une étape de nettoyage, brossage, séchage, polissage, ou une activation plasma, par exemple à base d'oxygène ou d'azote.

L'étape d'assemblage peut correspondre à la mise en contact intime du substrat donneur 1 avec le substrat support 7 par adhésion moléculaire et/ou collage électrostatique. Pour faciliter l'assemblage des deux substrats 1, 7, on prévoit de former au moins une couche d'assemblage diélectrique 7b sur la face 6 à assembler du substrat support 7. On pourra également ou alternativement prévoir de former également une couche d'assemblage sur la face à assembler 4 du substrat donneur 1, préférentiellement avant la formation du plan de fragilisation 2. Dit autrement, la couche d'assemblage diélectrique 7 peut être formée, en partie au moins, sur l'un et/ou l'autre des deux substrats 1, 7

La couche d'assemblage diélectrique 7b est par exemple constituée d'oxyde de silicium, ou plus généralement d'un oxyde tel que du Ta2O5, du ZrO2 ou du HfO (ces oxydes pouvant comme le SiO2 être formés par dépôts), ou de nitrure de silicium et présente une épaisseur comprise entre quelques nanomètres et quelques µm. La couche d'assemblage 7b peut être composée d'un empilement de couches diélectriques de natures différentes. La couche d'assemblage diélectrique 7b peut être élaborée selon les différentes techniques connues de l'état de l'art, tels des traitements thermiques d'oxydation ou de nitruration, des dépôts chimiques (PECVD, LPCVD...), etc.

D'une manière générale on favorisera les techniques de dépôts ou de formation de la couche d'assemblage conduisant à y incorporer peu d'hydrogène. On note que le choix du matériau formant cette couche d'assemblage, de son épaisseur, et de sa technique de formation n'est pas entièrement libre. Ce choix peut être notamment dicté par les propriétés d'isolation électrique, de propagation des ondes acoustique et/ou d'adhésion de cette couche dans la structure finale et selon l'application visé. On note enfin qu'il est généralement plus aisé et universel de former la couche d'assemblage par dépôt, notamment un dépôt d'oxyde, car cette méthode de formation peut se réaliser indépendamment de la nature du support et à des température relativement modérées, inférieures à 1000°C ou 950°C ou même inférieures à 900°C, ce qui peut parfois être imposé par la nature de la partie massive du support 7a ou par l'existence d'une couche de piégeage 7c.

Selon une caractéristique importante d'un mode de mise en oeuvre, on prendra soin à ce que la couche d'assemblage diélectrique 7b présente une concentration d'hydrogène inférieure à la concentration moyenne en hydrogène dans la première couche 3. En estimant qu'une grande majorité de l'hydrogène de la première couche 3 provient de l'hydrogène implantée pour former le plan de fragilisation 2, la concentration moyenne d'hydrogène peut être déterminée en divisant la dose implantée (en at/cm^2) par l'épaisseur de la première couche (en cm). Elle est typiquement comprise entre 10^20 at/cm^3 et 10^22 at/cm^3. A titre d'exemple, dans le cas où la couche d'assemblage 7b est constituée d'un oxyde de silicium déposé sur le substrat support, on procédera à un recuit de cet oxyde, avant l'étape d'assemblage, de manière à faire exodiffuser une grande partie de l'hydrogène qu'elle contient.

D'une manière générale, on peut prévoir une étape de recuit de la couche d'assemblage 7b qui vise à porter cette couche diélectrique à une température supérieure au traitement thermique de préparation de la première couche reportée, que l'on présentera ultérieurement dans cette description. On peut ainsi porter cette couche à une température de 600°C, 700°C, voire même 800°C ou plus. La concentration moyenne en hydrogène dans la couche d'assemblage 7b, après cette étape d'exodiffusion, peut ainsi être inférieure 5.10^20 at/cm^3, ou avantageusement inférieure à 10^18 at/cm^3, ou plus avantageusement inférieure à 10^18 at/cm3. On notera que le recuit peut venir modifier d'autres caractéristiques de la couche d'assemblage que sa concentration en hydrogène. Il peut notamment réduire la diffusivité de l'hydrogène, c'est à dire la capacité de cette espèce à diffuser dans le matériau constituant la couche d'assemblage, si bien que l'hydrogène même en concentration relativement importante (de l'ordre de 10^20 at/cm^3) est moins susceptible de diffuser vers la première couche 3.

Alternativement ou en complément à ce mode de mise en oeuvre, on peut prévoir de munir la couche d'assemblage diélectrique 7b d'une couche barrière prévenant la diffusion d'hydrogène vers la première couche 3. A titre d'exemple, la couche d'assemblage 7b peut être formée d'un empilement constitué d'une première couche d'oxyde, par exemple d'oxyde de silicium, disposé du côté du substrat support 7a (ou de la couche de piégeage 7c, lorsque celle-ci est présente) et d'une couche de nitrure de silicium disposée du côté de la première couche 3 ferroélectrique. Cette couche de nitrure prévient la diffusion de l'hydrogène éventuellement présent dans la couche d'oxyde de silicium vers la première couche ferroélectrique 3.

Selon une autre approche encore, on peut prévoir que la couche d'assemblage diélectrique présente une concentration en hydrogène quelconque, mais que cette couche présente une très faible diffusivité de cet hydrogène, qui y reste donc suffisamment piégé pour ne pas diffuser de manière notable vers la couche mince 3.

Une telle couche peut être formée d'un oxyde, par exemple un oxyde de silicium SiON, présentant de l'azote dans un ratio azote/ oxygène supérieur ou égale à 0,01, à 0,05 ou à 0,1. Lorsque la couche diélectrique d'assemblage 7b est à base d'oxyde de silicium SiON, ce qui est très usuel car ce matériau présente des caractéristiques de formation, d'adhésion, d'isolation électrique et de propagation des ondes acoustiques bien connu, on pourra choisir de ne pas excéder un ratio azote/oxygène n'excédant pas 0,1 ou 0,25 pour ne pas modifier excessivement ces caractéristiques et conserver un comportement équivalent ou proche de celui d'un simple oxyde de silicium SiO2. On note qu'une telle couche d'oxyde riche en azote peut facilement être constituée par une technique de dépôt par exemple de PECVD, dont un des gaz porteurs au moins peut être choisi pour être de l'azote qui peut s'incorporer de manière maîtrisée dans la couche d'oxyde. Le ratio azote/oxyde peut être mesuré par une technique dite EDX (pour « energy-dispersive X-ray spectroscopy » ou « spectroscopie aux rayons X à dispersion d'énergie » en français) ou élaboré a partir des mesures d'azote et d'oxygène déterminés par mesures SIMS (spectrométrie de masse à ions secondaires) dans la couche d'oxyde 4.

La couche diélectrique d'assemblage 7b peut consister sur toute son épaisseur d'un matériau présentant une faible diffusivité, par exemple un oxyde comprenant de l'azote comme mentionné ci-dessus.

Alternativement, on peut prévoir que seule une couche barrière prévenant la diffusion d'hydrogène vers la première couche 3 soit constituée de ce matériau présentant une faible diffusivité comme cela a été présenté dans l'alternative précédente. Par exemple, une couche d'oxyde de silicium présentant une concentration élevée d'hydrogène peut être formée par dépôt sur le substrat support, et cette couche préparée à l'aide d'un plasma à base d'azote pour incorporer cet azote superficiellement. On forme ainsi sur cette épaisseur superficielle une couche barrière de SiO riche en azote qui prévient la diffusion de l'hydrogène contenue dans le reste de l'oxyde.

Lorsque la partie massive du support 7a est pourvu en surface d'une couche de piégeage de charges 7c comprenant du silicium, on peut envisager de former la couche diélectrique d'assemblage 7b par oxydation thermique d'une partie superficielle de cette couche de piégeage en la traitant dans une atmosphère oxydante à une température modérée inférieure à 950°C et préférentiellement comprise entre 800°C et 900°C. On évite ainsi de détériorer, par exemple par recristallisation, la couche de piégeage de charges 7c en la soumettant à une température élevée, supérieure à 950°C ou 900°C. On pourra introduire éventuellement une étape de polissage de la surface ainsi oxydée de la couche de piégeage 7c afin de la rendre compatible avec l'étape ultérieur d'assemblage.

Quelle que soit la nature de la couche d'assemblage diélectrique 7b et des traitements qu'elle a subi, on dispose à l'issue de cette étape d'assemblage, de l'ensemble représenté sur la figure 1C comprenant les deux substrats associés, la face plane 6 du substrat support 7 adhérant à la face plane 4 du substrat donneur 1, par l'intermédiaire d'une couche d'assemblage diélectrique 7b.

L'ensemble est alors traité pour détacher la première couche 3 de matériau ferroélectrique du substrat donneur 1, par clivage au niveau du plan de fragilisation 2.

Cette étape de détachement peut ainsi comprendre l'application à l'ensemble d'un traitement thermique dans une gamme de température de l'ordre de 80°C à 300° pour permettre le transfert de la première couche 3 sur le substrat support 7. En remplacement ou en complément du traitement thermique, cette étape peut comprendre l'application d'une lame ou un jet de fluide gazeux ou liquide, ou de tout autre effort de nature mécanique au niveau du plan de fragilisation 2.

Suite à cette étape de détachement, on obtient la structure 9 représentée à la figure 1D. Cette structure 9 comprend la première couche 3 de matériau ferroélectrique comprenant une première face libre 8 et une deuxième face 4 (correspondant à la première face du substrat donneur) disposée sur le substrat support 7, la couche diélectrique d'assemblage 7b étant disposée entre la première couche 3 et le reste du support 7.

Les figures 2A à 2D représentent un deuxième mode de réalisation, particulièrement adapté à la réalisation d'une structure 9 hétérogène, dans laquelle la première couche 3 présente un coefficient de dilatation thermique bien différent de celui du support, par exemple présentant une différence de plus de 10%.

En référence à la figure 2A, le substrat donneur 1 est dans ce cas composé d'une couche épaisse de matériau ferroélectrique 1a, possédant les mêmes propriétés que celles décrites pour le bloc massif de matériaux ferroélectrique en relation avec le premier mode de réalisation, et d'un substrat manipulateur 1b.

Le substrat manipulateur 1b est avantageusement constitué d'un matériau (ou d'une pluralité de matériaux) lui conférant un coefficient de dilatation thermique proche de celui composant le substrat support 7. Par « proche », on signifie que la différence de coefficient de dilatation thermique du substrat manipulateur 1b et de celui du support est moindre, en valeur absolue, que la différence de dilatation thermique du bloc massif du matériau ferroélectrique et de celui du substrat support 7.

Préférentiellement, le substrat manipulateur 1b et le substrat support 7 présentent un coefficient de dilatation thermique identique. Lors de l'assemblage du substrat donneur 1 et du support 7, on forme une structure apte à supporter un traitement thermique à une température relativement élevée. Pour des raisons de simplicité de mise en oeuvre, cela peut être obtenu en choisissant le substrat manipulateur 1b pour qu'il soit constitué du même matériau que celui du substrat support 7.

Pour former le substrat donneur 1 de ce mode de réalisation, on assemble préalablement un bloc massif de matériau ferroélectrique avec le substrat manipulateur 1b, par exemple selon une technique de collage par adhésion moléculaire telle que cela a été décrit préalablement. Puis, on forme la couche de matériau ferroélectrique 1a par amincissement, par exemple par meulage et/ou polissage mécano-chimique et/ou gravure. Avant l'assemblage on peut avoir prévu la formation d'une couche d'adhésion (par exemple par dépôt d'oxyde de silicium et/ou de nitrure de silicium) sur l'une et/ou l'autre des faces mises en contact. L'assemblage peut comprendre l'application d'un traitement thermique de faible température (compris par exemple entre 50 et 300°C, typiquement 100°C) permettant de renforcer suffisamment l'énergie de collage pour permettre l'étape suivante d'amincissement.

Le substrat manipulateur 1b est choisi pour présenter une épaisseur sensiblement équivalente à celle du substrat support 7. L'étape d'amincissement est conduite de telle sorte que la couche épaisse 1a présente une épaisseur suffisamment faible pour que les contraintes générées lors des traitements thermiques appliqués dans la suite du procédé soient d'intensité réduite. Dans le même temps, cette épaisseur est suffisamment importante pour pouvoir y prélever la première couche 3, ou une pluralité de telles couches. Cette épaisseur peut par exemple être comprise entre 5 et 400 µm.

Les étapes suivantes du procédé de ce second mode de mise en oeuvre sont équivalentes à celles des étapes décrites dans le premier mode. On procède à l'implantation d'hydrogène au sein de la couche épaisse 1a pour générer un plan de fragilisation 2 qui marque la séparation de la première couche 3 du reste 5 du substrat donneur 1, comme cela est représenté sur la figure 2B. Cette étape est suivie de l'étape d'assemblage du substrat donneur 1 sur le substrat support 7, tel que cela est représenté sur la figure 2C. On aura prévu une couche d'assemblage diélectrique 7b entre le substrat donneur 1 et le substrat support 7, cette couche d'assemblage présentant les mêmes propriétés que celles prévues dans le cadre du premier mode de mise en oeuvre. On note que s'il est choisi de former une couche d'oxyde de silicium (ou un diélectrique de tout autre nature nécessitant un recuit d'exodiffusion de l'hydrogène) sur la face à assembler du substrat donneur 1 de ce mode de réalisation, on limitera son épaisseur à quelques nanomètres, par exemple inférieure à 10 nm ou 50nm, car il peut être délicat d'appliquer le recuit d'exodiffusion à cette couche sans risquer de détériorer le substrat donneur 1 composé d'un assemblage de matériaux présentant des coefficients de dilatation thermique bien différents.

On détache ensuite la première couche 3 du reste du substrat 5 pour obtenir la structure 9 représentée sur la figure 2D.

Ce mode de réalisation est avantageux en ce que l'assemblage formé du substrat donneur 1 et du support 7 peut être exposé à une température bien plus élevée que celle appliquée dans le cadre du premier mode de réalisation, sans risque de fracture incontrôlée de l'un des substrats ou de délamination du substrat donneur 1. La structure équilibrée, en termes de coefficient de dilatation thermique de cet assemblage, permet ainsi de faciliter l'étape de détachement de la première couche 3 en exposant l'assemblage à une température relativement élevée, par exemple comprise entre 100°C et 600°C.

Quel que soit le mode de mise en oeuvre choisi, et comme cela a été précisé précédemment, des étapes de préparation de la première couche 3 sont ensuite nécessaires pour former une couche mince 10 présentant une qualité cristalline et de surface satisfaisante.

Comme cela est représenté sur la figure 3A, ce procédé comporte tout d'abord un traitement thermique de la face libre 8 de la première couche 3 reportée. Ce traitement thermique permet de guérir des défauts cristallins présents dans la première couche 3. En outre, il contribue à consolider le collage entre cette couche 3 et le support 7. Les études exposées précédemment ont montré que ce traitement thermique avait également pour effet, s'il présentait une température suffisante, de provoquer la diffusion de l'hydrogène contenue dans la première couche 3, notamment dans sa portion superficielle, et provoquer la transformation multidomaine de cette portion superficielle. La portion superficielle peut présenter une épaisseur de l'ordre de 50nm ou moins et se développer sur toute l'étendue de la couche 3. A l'issue du traitement thermique, la couche ferroélectrique 10 présente une concentration d'hydrogène relativement constante dans son épaisseur, et comprise entre 10^18 et 10^19 at/cm^3. On note que grâce aux propriétés de la couche d'assemblage 7b exposés précédemment, l'hydrogène contenue dans cette couche d'assemblage n'est pas susceptible de diffuser vers la couche mince 3 au cours du recuit et/ou de se piéger au niveau de l'interface existant entre la couche d'assemblage 7b et cette couche. On évite ainsi de former un gradient de concentration d'hydrogène dans cette zone enterrée à proximité de cette interface, et on prévient de la sorte de convertir cette zone pour qu'elle présente une caractéristique multidomaine.

Un traitement thermique de préparation de la couche mince 10 conforme porte la structure à une température comprise entre 300°C et la température de Curie du matériau ferroélectrique (et préférentiellement supérieure ou égale à 450°C, 500° ou 550° pour favoriser la diffusion de l'hydrogène) pendant une durée comprise entre 30 minutes et 10 heures. Le traitement thermique peut prévoir une rampe douce. Ce traitement thermique est préférentiellement réalisé en exposant la face libre 8 de la première couche 3 à une atmosphère gazeuse oxydante ou neutre, c'est à dire sans recouvrir cette face de la couche mince d'une couche de protection qui pourrait prévenir l'exodiffusion de l'hydrogène.

En référence à la figure 3B, le procédé de préparation comporte également, après le traitement thermique, un amincissement de la couche mince 3. Cet amincissement peut correspondre au polissage de la face libre 8 de la couche mince 3, par exemple par des techniques d'amincissement mécanique, mécano-chimique et/ou de gravure chimique. Il permet de préparer la face libre 8 pour qu'elle présente une rugosité faible, par exemple inférieure à 0,5nm RMS 5x5 µm par mesure par force atomique (AFM) et d'enlever la portion superficielle multidomaine de la couche mince 10. On prévoit généralement un enlèvement de 100 à 300nm d'épaisseur, pour atteindre l'épaisseur cible de la couche mince 10, et dans tous les cas une épaisseur supérieure à celle de la portion superficielle multidomaine.

On constitue ainsi une couche mince monodomaine sur toute son épaisseur présentant les qualités requises d'état de surface, de qualité cristalline. La couche d'assemblage diélectrique 7b présentant une concentration d'hydrogène inférieure à celle de la première couche 3 ou comprenant une barrière à la diffusion d'hydrogène vers la première couche 3, évite d'accumuler l'hydrogène en excès dans une zone enterrée de la couche mince 10, située à proximité de l'interface d'assemblage. On prévient ainsi la transformation multidomaine de cette zone, qu'il ne serait pas possible d'éliminer.

Bien entendu l'invention n'est pas limitée aux modes de mise en oeuvre décrits et on peut y apporter des variantes de réalisation sans sortir du cadre de l'invention tel que défini par les revendications.

## Revendications

1. Procédé de préparation d'une couche mince monodomaine (10) en matériau ferroélectrique comprenant les étapes suivantes
- une implantation d'espèces légères dans une première face (4) d'un substrat donneur ferroélectrique (1) pour former un plan de fragilisation (2) et définir une première couche (3) entre le plan de fragilisation (2) et la première face (4) du substrat donneur (1);
- l'assemblage de la première face (4) du substrat donneur (1) à un substrat support (7) par l'intermédiaire d'une couche d'assemblage diélectrique (7b), ;
- la fracture du substrat donneur (1) au niveau du plan de fragilisation (2) pour reporter la première couche (3) sur le substrat support (7) et exposer une face libre (8) de la première couche (3);
- la finition de la première couche (3), cette finition comprenant un traitement thermique de la face libre (8) de la première couche (3), suivi d'un amincissement de la première couche (3) pour former la couche mince monodomaine (10) ;
la couche d'assemblage diélectrique (7b) comprenant un oxyde prévenant la diffusion d'hydrogène vers la première couche, ou la couche d'assemblage diélectrique (7b) comprenant une barrière prévenant la diffusion d'hydrogène vers la première couche (3).

2. Procédé selon la revendication précédente, dans lequel l'amincissement comprend un polissage mécano-chimique appliqué sur la face libre (8) de la première couche (3).

3. Procédé selon l'une des revendications précédentes, dans lequel le traitement thermique s'effectue à une température comprise entre 300°C et la température de Curie du matériau ferroélectrique composant la première couche (3), et pendant une durée comprise entre 30 minutes et 10 heures.

4. Procédé selon l'une des revendications précédentes, dans lequel le traitement thermique s'effectue sous une atmosphère gazeuse oxydante ou neutre.

5. Procédé selon l'une des revendications précédentes, dans lequel le substrat donneur (1) comprend un matériau ferroélectrique choisi parmi du LiTaO3 ou du LiNbO3.

6. Procédé selon l'une des revendications précédentes, dans lequel le matériau ferroélectrique présente une direction cristalline comprise entre 30° et 60°RY.

7. Procédé selon l'une des revendications précédentes, dans lequel le matériau du substrat support (7) est du silicium.

8. Procédé selon l'une des revendications précédentes, dans lequel le substrat donneur (1) est un bloc de matériau massif.

9. Procédé selon l'une des revendications précédentes, dans lequel le substrat donneur (1) comprend une couche épaisse (1a) en matériau ferroélectrique disposée sur un substrat manipulateur (1b).

10. Procédé selon la revendication précédente, dans lequel le substrat manipulateur (1b) présente un coefficient de dilatation thermique identique ou proche du coefficient de dilatation thermique du support (7).

11. Procédé selon l'une des revendications précédentes, dans lequel le matériau de la première couche (3) et le matériau du substrat support (7) présentent des coefficients de dilatation thermique différents.

12. Procédé selon l'une des revendications précédentes dans lequel la couche d'assemblage diélectrique (7b) comprend un oxyde présentant de l'azote dans un ratio azote/ oxygène supérieur ou égale à 0,01 ou 0,05.

13. Procédé selon l'une des revendications précédentes dans lequel la couche d'assemblage diélectrique (7b) comprend un oxyde de silicium présentant de l'azote dans un ratio azote/ oxygène compris entre 0,01 et 0,25 ou entre 0,05 et 0,01.

14. Procédé selon l'une des revendications précédentes dans lequel la couche d'assemblage diélectrique (7b) est formée d'un empilement comprenant une première couche d'oxyde disposé du côté du substrat support (7a) et d'une couche de nitrure de silicium disposée du côté de la première couche (3).

15. Dispositif comprenant :
- une couche mince entièrement monodomaine (10) en matériau ferroélectrique ;
- une couche d'assemblage diélectrique (7b) en contact avec la couche mince (10) et comprenant un oxyde prévenant la diffusion d'hydrogène vers la couche mince (10), ou comprenant une barrière prévenant la diffusion d'hydrogène vers la couche mince (10);
- un support (7) en contact avec la couche diélectrique.

16. Dispositif selon la revendication précédente dans lequel le substrat support (7) est muni d'une couche de piégeage de charges (7c) disposé entre une partie massive (7a) du support et la couche d'assemblage diélectrique (7b) .

17. Dispositif selon l'une des revendications 15 à 16 dans lequel la couche d'assemblage diélectrique (7b) comprend un oxyde présentant de l'azote dans un ratio azote/ oxygène supérieur ou égale à 0,01 ou 0,05.

18. Dispositif selon l'une des revendications l'une des revendications 15 à 17 dans lequel la couche d'assemblage diélectrique (7b) comprend un oxyde de silicium présentant de l'azote dans un ratio azote/ oxygène compris entre 0,01 et 0,25 ou entre 0,05 et 0,1.

19. Dispositif selon l'une des revendications 15 à 18 dans lequel la couche d'assemblage diélectrique (7b) est formée d'un empilement comprenant une première couche d'oxyde disposé du côté du substrat support (7a) et d'une couche de nitrure de silicium disposée du côté de la couche mince (10) .

## Patentansprüche

1. Verfahren zum Herstellen einer monodomänen dünnen Schicht (10) aus ferroelektrischem Material, umfassend die folgenden Schritte:
- Implantieren von leichten Spezies in eine erste Fläche (4) eines ferroelektrischen Donorsubstrats (1) zum Ausbilden einer Versprödigungsebene (2) und Definieren einer ersten Schicht (3) zwischen der Versprödigungsebene (2) und der ersten Fläche (4) des Donorsubstrats (1);
- Verbinden der ersten Fläche (4) des Donorsubstrats (1) mit einem Trägersubstrat (7) über eine dielektrische Verbindungsschicht (7b);
- Brechen des Donorsubstrats (1) an der Versprödigungsebene (2) zum Übertragen der ersten Schicht (3) auf das Trägersubstrat (7) und Freilegen einer freien Fläche (8) der ersten Schicht (3);
- Endbearbeiten der ersten Schicht (3), diese Endbearbeitung umfassend eine Wärmebehandlung der freien Fläche (8) der ersten Schicht (3), gefolgt von einem Ausdünnen der ersten Schicht (3) zum Ausbildern der monodomänen dünnen Schicht (10);
die dielektrische Verbindungsschicht (7b) umfassend ein Oxid, das die Diffusion von Wasserstoff in Richtung der ersten Schicht verhindert, oder die dielektrische Verbindungsschicht (7b) umfassend eine Barriere, die die Diffusion von Wasserstoff in Richtung der ersten Schicht (3) verhindert.

2. Verfahren nach dem vorstehenden Anspruch, wobei das Ausdünnen ein mechanisch-chemisches Polieren umfasst, das auf die freie Fläche (8) der ersten Schicht (3) angewendet wird.

3. Verfahren nach einem der vorstehenden Ansprüche, wobei die Wärmebehandlung bei einer Temperatur zwischen 300 °C und der Curie-Temperatur des ferroelektrischen Materials, aus dem die erste Schicht (3) besteht, und für einen Zeitraum zwischen 30 Minuten und 10 Stunden erfolgt.

4. Verfahren nach einem der vorstehenden Ansprüche, wobei die Wärmebehandlung in einer oxidierenden oder neutralen Gasatmosphäre erfolgt.

5. Verfahren nach einem der vorstehenden Ansprüche, wobei das Donorsubstrat (1) ein ferroelektrisches Material umfasst, das aus LiTaO3 oder LiNbO3 ausgewählt ist.

6. Verfahren nach einem der vorstehenden Ansprüche, wobei das ferroelektrische Material eine Kristallrichtung zwischen 30° und 60°RY aufweist.

7. Verfahren nach einem der vorstehenden Ansprüche, wobei das Material des Trägersubstrats (7) Silicium ist.

8. Verfahren nach einem der vorstehenden Ansprüche, wobei das Donorsubstrat (1) ein Block aus massivem Material ist.

9. Verfahren nach einem der vorstehenden Ansprüche, wobei das Donorsubstrat (1) eine dicke Schicht (1a) aus ferroelektrischem Material umfasst, die auf einem Handhabungssubstrat (1b) angeordnet ist.

10. Verfahren nach dem vorstehenden Anspruch, wobei das Handhabungssubstrat (1b) einen Wärmeausdehnungskoeffizienten aufweist, der gleich oder nahe dem Wärmeausdehnungskoeffizienten des Trägers (7) ist.

11. Verfahren nach einem der vorstehenden Ansprüche, wobei das Material der ersten Schicht (3) und das Material des Trägersubstrats (7) unterschiedliche Wärmeausdehnungskoeffizienten aufweisen.

12. Verfahren nach einem der vorstehenden Ansprüche, wobei die dielektrische Verbindungsschicht (7b) ein Oxid umfasst, das Stickstoff in einem Stickstoff-/Sauerstoffverhältnis von größer als oder gleich 0,01 oder 0,05 aufweist.

13. Verfahren nach einem der vorstehenden Ansprüche, wobei die dielektrische Verbindungsschicht (7b) Siliciumoxid umfasst, das Stickstoff in einem Stickstoff-/Sauerstoffverhältnis zwischen 0,01 und 0,25 oder zwischen 0,05 und 0,01 aufweist.

14. Verfahren nach einem der vorstehenden Ansprüche, wobei die dielektrische Verbindungsschicht (7b) aus einem Stapel, umfassend eine erste Oxidschicht, die auf der Seite des Trägersubstrats (7a) angeordnet ist, und einer Siliciumnitridschicht ausgebildet ist, die auf der Seite der ersten Schicht (3) angeordnet ist.

15. Vorrichtung, umfassend:
- eine vollständige monodomäne dünne Schicht (10) aus ferroelektrischem Material;
- eine dielektrische Verbindungsschicht (7b) in Kontakt mit der dünnen Schicht (10) und umfassend ein Oxid, das die Diffusion von Wasserstoff in Richtung der dünnen Schicht (10) verhindert, oder umfassend eine Barriere, die die Diffusion von Wasserstoff in Richtung der dünnen Schicht (10) verhindert;
- einen Träger (7) in Kontakt mit der dielektrischen Schicht.

16. Vorrichtung nach dem vorstehenden Anspruch, wobei das Trägersubstrat (7) mit einer Ladungseinfangschicht (7c) versehen ist, die zwischen einem massiven Teil (7a) des Trägers und der dielektrischen Verbindungsschicht (7b) angeordnet ist.

17. Vorrichtung nach einem der Ansprüche 15 bis 16, wobei die dielektrische Verbindungsschicht (7b) ein Oxid umfasst, das Stickstoff in einem Stickstoff-/Sauerstoffverhältnis von größer als oder gleich 0,01 oder 0,05 aufweist.

18. Vorrichtung nach einem der Ansprüche 15 bis 17, wobei die dielektrische Verbindungsschicht (7b) Siliciumoxid umfasst, das Stickstoff in einem Stickstoff-/Sauerstoffverhältnis zwischen 0,01 und 0,25 oder zwischen 0,05 und 0,1 aufweist.

19. Vorrichtung nach einem der Ansprüche 15 bis 18, wobei die dielektrische Verbindungsschicht (7b) aus einem Stapel, umfassend eine erste Oxidschicht, die auf der Seite des Trägersubstrats (7a) angeordnet ist, und einer Siliciumnitridschicht ausgebildet ist, die auf der Seite der dünnen Schicht (10) angeordnet ist.

## Claims

1. A method for preparing a thin monodomain layer (10) of ferroelectric material comprising the following steps:
- implanting light species in a first face (4) of a ferroelectric donor substrate (1) to form an embrittlement plane (2) and define a first layer (3) between the embrittlement plane (2) and the first face (4) of the donor substrate (1);
- assembling the first face (4) of the donor substrate (1) to a support substrate (7) by means of a dielectric assembly layer (7b);
- fracturing the donor substrate (1) at the embrittlement plane (2) in order to transfer the first layer (3) onto the support substrate (7) and expose a free face (8) of the first layer (3);
- finishing the first layer (3), this finishing comprising heat treatment of the free face (8) of the first layer (3), followed by thinning of the first layer (3) to form the thin monodomain layer (10);
the dielectric assembly layer (7b) comprising an oxide preventing the diffusion of hydrogen toward the first layer, or the dielectric assembly layer (7b) comprising a barrier preventing the diffusion of hydrogen toward the first layer (3).

2. The method according to the preceding claim, wherein the thinning comprises chemical-mechanical polishing applied to the free face (8) of the first layer (3).

3. The method according to one of the preceding claims, wherein the heat treatment is carried out at a temperature between 300°C and the Curie temperature of the ferroelectric material making up the first layer (3), and for a period of between 30 minutes and 10 hours.

4. The method according to one of the preceding claims, wherein the heat treatment is carried out under an oxidizing or neutral gaseous atmosphere.

5. The method according to one of the preceding claims, wherein the donor substrate (1) comprises a ferroelectric material selected from LiTaO3 or LiNbO3.

6. The method according to one of the preceding claims, wherein the ferroelectric material has a crystal direction of between 30° and 60°RY.

7. The method according to one of the preceding claims, wherein the material of the support substrate (7) is silicon.

8. The method according to one of the preceding claims, wherein the donor substrate (1) is a block of solid material.

9. The method according to one of the preceding claims, wherein the donor substrate (1) comprises a thick layer (1a) of ferroelectric material arranged on a manipulator substrate (1b).

10. The method according to the preceding claim, wherein the manipulator substrate (1b) has a thermal expansion coefficient identical or close to the thermal expansion coefficient of the support (7).

11. The method according to one of the preceding claims, wherein the material of the first layer (3) and the material of the support substrate (7) have different thermal expansion coefficients.

12. The method according to one of the preceding claims, wherein the dielectric assembly layer (7b) comprises an oxide having nitrogen in a nitrogen/oxygen ratio greater than or equal to 0.01 or 0.05.

13. The method according to one of the preceding claims, wherein the dielectric assembly layer (7b) comprises a silicon oxide having nitrogen in a nitrogen/oxygen ratio of between 0.01 and 0.25 or between 0.05 and 0.01.

14. The method according to one of the preceding claims, wherein the dielectric assembly layer (7b) is formed by a stack comprising a first oxide layer arranged on the side of the support substrate (7a) and a layer of silicon nitride arranged on the side of the first layer (3).

15. A device comprising:
- a thin fully monodomain layer (10) of ferroelectric material;
- a dielectric assembly layer (7b) in contact with the thin layer (10) and comprising an oxide preventing the diffusion of hydrogen toward the thin layer (10), or comprising a barrier preventing the diffusion of hydrogen toward the thin layer (10);
- a support (7) in contact with the dielectric layer.

16. The device according to the preceding claim, wherein the support substrate (7) is provided with a charge trapping layer (7c) arranged between a solid part (7a) of the support and the dielectric assembly layer (7b).

17. The device according to one of claims 15 to 16, wherein the dielectric assembly layer (7b) comprises an oxide having nitrogen in a nitrogen/oxygen ratio greater than or equal to 0.01 or 0.05.

18. The device according to one of claims 15 to 17, wherein the dielectric assembly layer (7b) comprises a silicon oxide having nitrogen in a nitrogen/oxygen ratio of between 0.01 and 0.25 or between 0.05 and 0.1.

19. The device according to one of claims 15 to 18, wherein the dielectric assembly layer (7b) is formed by a stack comprising a first oxide layer arranged on the side of the support substrate (7a) and a layer of silicon nitride arranged on the side of the thin layer (10).
